Europäisches Patentamt

European Patent Office

Office européen des brevets

(11) Publication number: **0 288 236**
**A2**

# EUROPEAN PATENT APPLICATION

(21) Application number: 88303498.5

(22) Date of filing: 19.04.88

(51) Int. Cl.⁴: **H01L 39/24**

(30) Priority: 20.04.87 JP 95410/87
22.04.87 JP 97373/87

(43) Date of publication of application:
26.10.88 Bulletin 88/43

(84) Designated Contracting States:
CH DE GB LI

(71) Applicant: HITACHI, LTD.
6, Kanda Surugadai 4-chome Chiyoda-ku
Tokyo 100(JP)

(72) Inventor: Ibaraki, Yoshiro
679-13, Shoei
Tsukuba-shi(JP)
Inventor: Kanamaru, Masatoshi Hitachi
Tsukuba
Hausu 1-205 2625-3, Shimoinayoshi
Chiyodamura Niihari-gun Ibaraki-ken(JP)
Inventor: Endo, Yoshishige
4384 Kandatsumachi
Tsuchiura-shi(JP)
Inventor: Okada, Ryoji
Hitachi Tsukuba Hausu 1-305 2625-3,
Shimoinayoshi
Chiyodamura Niihari-gun Ibaraki-ken(JP)
Inventor: Natori, Tatsuo
120-33, Oaota
Kashiwa-shi(JP)
Inventor: Haneda, Mitsuaki
114-8, Asahimachi Tomobemachi
Nishiibaraki-gun Ibaraki-ken(JP)
Inventor: Hakuraku, Yoshinori
43-2-47, Murasakibaru-3-chome
Kagoshima-shi(JP)

(74) Representative: Calderbank, Thomas Roger et
al
MEWBURN ELLIS & CO. 2/3 Cursitor Street
London EC4A 1BQ(GB)

(54) Process for producing high temperature superconducting material.

(57) A process for producing a high temperature superconducting material comprises reacting a mixture of ultrafine powders (A,B,C) in a furnace to obtain a superconducting raw material of powder form (a) and molding and sintering the superconducting raw material to a desired shape according to a slip casting method. This enables production of a uniform product having high temperature supercon- ducting properties via a step of excellent reactivity.

# FIG. 1

```
┌──────────┐   ┌──────────┐   ┌──────────┐
│ULTRAFINE │   │ULTRAFINE │   │ULTRAFINE │
│POWDER A  │   │POWDER B  │   │POWDER C  │
└──────────┘   └──────────┘   └──────────┘

┌──────────┐   ┌──────────┐   ┌──────────┐
│DISPERSION│   │DISPERSION│   │DISPERSION│
└──────────┘   └──────────┘   └──────────┘

        ┌─────────────────────┐
        │UNIFORM  DISPERSION   │
        │MIXING                │
        └─────────────────────┘

        ┌─────────────────────┐
        │    EVAPORATION       │
        └─────────────────────┘

        ┌─────────────────────┐
        │ULTRAFINE  POWDER     │
        │MIXTURE : a           │
        └─────────────────────┘

        ┌─────────────────────┐
        │  HEATING · REACTION  │
        └─────────────────────┘

        ┌─────────────────────┐
        │HIGH  TEMPERATURE     │
        │SUPERCONDUCTING       │
        │RAW  MATERIAL : b     │
        └─────────────────────┘

┌──────────┐  ┌──────────┐  ┌──────────┐
│ SOLVENT  │  │ KNEADING │  │DISPERSANT│
└──────────┘  └──────────┘  └──────────┘

              ┌──────────┐
              │ SLIP · c │
              └──────────┘
```

# PROCESS FOR PRODUCING HIGH TEMPERATURE SUPERCONDUCTING MATERIAL

The present invention relates to a process for producing a superconducting wire and more particularly to a process for producing a high temperature superconducting material suitable for obtaining a high critical transition temperature, a high critical magnetic field and a high critical current density.

The conventional process for producing a superconducting wire is described in an article entitled "Scale up of Powder Metallurgy Processed Nb-Al Multifilamentary Wire" in IEEE, Trans. Magnetics, MAG 19, No. 3 (May 1983), page 567.

Meanwhile, it is experimentally confirmed that superconducting compounds having a $B_1$ structure, when made into a thin film by sputtering, show a high critical transition temperature, a high critical magnetic field and a high critical current density. Production of a superconducting wire from a superconducting compound having a $B_1$ structure has conventionally been effected by forming a NbN film of $B_1$ structure directly on a Hastelloy tape, a carbon fiber, etc. by means of sputtering, as described in "Study on Production of a Superconducting NbN Wire" by Sugawara et al. in a preprint P381, 29P-L-8, 1985 of 32nd Associated Lectures on Applied Physics.

Tokano et al. found that a sintered body consisting of oxides of Ba, Y and Cu shows a superconducting phenomenon at a high temperature (93 K), as reported in the evening edition of the Yomiuri of Mar. 10, 1987. Since then, active researches are under way on such oxides at a large number of laboratories.

The technique described in the above IEEE literature has a problem in that the Nb and Al particles having particle diameters of 40-300 $\mu$m and 9-75 $\mu$m, respectively, have poor reactivity with each other and the resulting wire has low superconductivity.

NbN, when their grain are made smaller, shows a higher critical magnetic field and a higher critical current density, but the critical current density is smaller than that of a NbN film of $B_1$ structure formed on a saphire substrate. Therefore, production of a NbN wire has a limitation.

The technique by Tokano et al. has a problem in that since powders of large particle diameters (10-20 $\mu$m) are used, their reactivity is low and accordingly calcination must be repeated a plurality of times in order to obtain a superconducting material of desired properties.

An object of the present invention is to solve the above-mentioned problems of the prior art and to provide a high temperature superconducting material having excellent superconducting properties as represented by high critical magnetic field, high critical current density, etc.

In order to achieve the above object, the present invention provides a process for producing a high temperature superconducting material, which comprises uniformly dispersing and mixing a plurality of raw materials of ultrafine powder form in a predetermined stoichiometric composition to obtain an ultrafine powder mixture, reacting the mixture in a furnace to obtain a high temperature superconducting raw material, uniformly dispersing the raw material in a solvent to obtain a slip, and subjecting the slip to molding and sintering or coating the slip on a substrate followed by sintering.

In the first aspect of the present invention, there is provided a process for producing a high temperature superconducting material, which comprises:

a first step of uniformly dispersing and mixing a plurality of raw materials of ultrafine powder form in a predetermined stoichiometric composition to obtain an ultrafine powder mixture,

a second step of reacting the ultrafine powder mixture in a furnace to obtain a high temperature superconducting raw material, and

a third step of uniformly dispersing the high temperature superconducting raw material in a solvent to obtain a slip.

In order to achieve the above object, the present invention further provides a process for producing a high temperature superconducting material, which comprises uniformly mixing a plurality of raw materials in a predetermined stoichiometric composition to obtain a raw material mixture, reacting the mixture in a furnace to obtain a high temperature superconducting raw material, reacting the superconducting raw material in a plasma apparatus at a high temperature to obtain an ultrafine powder mixture, reacting the powder mixture in a furnace to obtain a powder having superconducting properties, uniformly dispersing the powder in a solvent to obtain a slip, and subjecting the slip to molding and sintering or coating the slip on a substrate followed by sintering.

In the second aspect of the present invention, there is provided a process for producing a high temperature superconducting material, which comprises:

a first step of uniformly mixing a plurality of raw materials of powder form in a predetermined stoichiometric composition to obtain a raw material mixture,

a second step of reacting the raw material mixture in a plasma apparatus at a high temperature to obtain an ultrafine powder mixture,

a third step of reacting the ultrafine powder mixture in a furnace to obtain a high temperature superconducting raw material having superconducting properties, and

fourth step of uniformly dispersing the high temperature superconducting raw material in a solvent to obtain a slip.

In the third aspect of the present invention, there is provided a process for producing a high temperature superconducting material, which comprises (a) pouring the slip obtained in the first or second aspect of the present invention into a cavity contained in a mold, at least one portion of the mold being made of potassium carbonate and water, to allow the master mold and core of the mold to absorb the water present in the slip and thereby to obtain a solidified slip and then (b) sintering the solidified slip in a furnace.

In the fourth aspect of the present invention, there is provided a process for producing a high temperature superconducting material, which comprises (a) pouring the slip obtained in the first or second aspect into a cavity contained in a mold, at least one portion of the mold being made of alumina, polyvinyl alcohol and water, to allow the mold to absorb the water present in the slip and thereby to obtain a solidified slip and then (b) sintering the solidified slip in a furnace.

In the fifth aspect of the present invention, there is provided a process for producing a high temperature superconducting material, which comprises (a) pouring the slip obtained in the first or second aspect into a cavity contained in a mold, at least one portion of the mold being made of calcined gypsum, a cellulose powder and water, to solidify the slip, (b) slowly heating the slip in a furnace to obtain a solidified slip and then (c) sintering the solidified slip in a furnace.

In the sixth aspect of the present invention, there is provided a process for producing a high temperature superconducting material, which comprises (a) pouring the slip obtained in the first or second aspect into a cavity in a mold, at least one portion of the mold being made of gypsum, a cellulose powder and water and the mold and cavity being formed by placing a polystyrol pattern having a silicone rubber film thereon in a molding flask, pouring a slurry into the flask and solidifying the slurry, dissolving the pattern with an organic solvent to chemically remove the pattern and then physically removing the silicone rubber film, (b) solidifying the slip in the mold (c) heating the mold containing the solidified slip in a furnace to reduce the strength of the mold and isolate the solidified slip and then (d) sintering the solidified slip.

In the seventh aspect of the present invention, there is provided a process for producing a high temperature superconducting material, which comprises coating the slip obtained in the first or second aspect on a metal tape and irradiating the coated surface with a laser beam.

In the drawings:

Fig. 1 and Fig. 2 are each a flow chart explaining an example of a process for producing a high temperature superconducting material according to the present invention.

Fig. 3 is a view showing the constitution of the key portion of a high frequency plasma apparatus used in the example of Fig. 2.

Fig. 4 and Fig. 5 are each a sectional view of a mold into which the slip obtained in Fig. 1 or 2 is to be casted.

Fig. 6 is a sectional view of a superconducting green body obtained in the mold of Fig. 5.

Fig. 7 is a view showing a state where a mold into which a slip is to be casted is in the course of production.

Fig. 8 is a view showing a state where a pattern is to be removed from the mold of Fig. 7.

Fig. 9 is a sectional view of the mold obtained in Fig. 8 into which a slip is in the course of casting.

Fig. 10 is a sectional view of a superconducting green body obtained in the mold of Fig. 9.

Fig. 11 is a sectional view of a mold into which the slip obtained in the example of Fig. 1 or 2 is to be casted.

Fig. 12 is a perspective view of a superconducting green body obtained in the mold of Fig. 11.

Fig. 13 is a side view of a pattern made of a foamed polystyrol.

Fig. 14 is a sectional view of a film-covered pattern obtained by forming a film on the surface of the pattern of Fig. 13.

Fig. 15 is a view showing a state where a mold is to be produced using the pattern of Fig. 14 as a core.

Fig. 16 is a view showing a state where a slip is in the course of casting into the mold of Fig. 15.

Fig. 17 is a perspective view of a pattern made of a foamed polystyrol.

Fig. 18 is a mold containing the pattern of Fig. 17.

Fig. 19 is a view showing an example of a state where a high temperature superconducting material is to be sintered with a laser beam.

Fig. 20 is a view showing the constitution of an apparatus for production of a high temperature superconducting tape, used in the example of Fig. 19.

In the first aspect of the present invention, it is preferable that in the first step the plurality of raw materials of ultrafine powder form are separately dispersed in advance and the resulting dispersions are mixed to obtain an ultrafine powder mixture. It is also desirable that the raw materials of ultrafine powder form have particle diameters of 1.000 Å or less.

In the second aspect of the present invention, it is desirable that the plasma apparatus is a high frequency plasma apparatus. It is also desirable that the ultrafine powder mixture obtained by reacting the raw material mixture in the plasma apparatus has particle diameters of 1,000 Å or less.

In the first and second aspect of the present invention, it is preferable that the plurality of raw materials of ultrafine powder form or of powder form comprise three components from the requirement of the final product, the first component being copper oxide (CuO) and the second and third components being two elements selected from oxides of Sr, Ba, Y and the rare earth elements such as La. As the second and third components, there can be used not only these oxides but also corresponding carbonates.

The raw materials may further contain, as a fourth component, one of the above oxides and carbonates other than those used in the second and third components.

It is desirable that in the first step the raw material mixture is reacted in a furnace at a temperature of 600-1,050°C.

It is also desirable that the above reaction of the raw material mixture in a furnace is conducted in an oxygen-containing atmosphere and the oxygen concentration in the atmosphere is selected so that a high temperature superconducting compound of intended composition can be obtained.

It is further desirable that in cooling the reaction product obtained from the reaction in a furnace, the cooling rate is controlled at 200°C/hr or above over a temperature range from the highest heating temperature to 200°C.

It is furthermore desirable that the highest heating temperature used in the solidification of the slip in a furnace or in laser irradiation is 600-1,050°C.

It is desirable that when the first component (CuO) of the plurality of raw materials of ultrafine powder form is given by a symbol "C", the second component a symbol "A" and the third component a symbol "B", the reaction in a furnace or in sintering produces a high temperature superconducting compound of perovskite type crystal structure as represented by $AB_2C_3$, $A_2BC_4$, $ABC_3$, $(AB)_3C_7$ or the like.

Examples of the stoichiometric composition include $YBa_2Cu_3O_{7-\delta}$, $HoBa_2Cu_3O_{7-\delta}$, $ErBa_2Cu_3O_{7-\delta}$, etc.

In the first aspect of the present invention, a mixture of a plurality of metal oxides of ultrafine powder form is used as a raw material for high temperature superconducting material; this raw material is superior in reactivity, uniformity of reaction and processability; as a result, there can be obtained a high temperature superconducting material having excellent superconducting properties in critical magnetic field, critical current density, etc.

Hence, in the first aspect of the present invention, a plurality of ultrafine powders are uniformly dispersed and mixed to obtain a ultrafine powder mixture; the powder mixture is reacted in a furnace to obtain a high temperature superconducting raw material; and the material is kneaded with a solvent and a dispersant to obtain a slip. This slip is casted into a desired mold or coated on a substrate, followed by sintering, whereby a high temperature superconducting material can be produced. In this process, since the raw materials of ultrafine powder form are used, their reactivity is very high and moreover their reaction is uniform. Thus, there can be produced a high temperature superconducting material of excellent superconducting properties in critical magnetic field and critical current density.

In the second aspect of the present invention, a mixture of a plurality of powder materials is reacted in a plasma apparatus to obtain an ultrafine powder mixture; the mixture is reacted in a furnace to obtain a high temperature superconducting raw material; this raw material is superior in reactivity, uniformity of reaction and moldability; as a result, there can be obtained a high temperature superconducting material having excellent superconducting properties in critical magnetic field, critical current density, etc.

Hence, in the second aspect of the present invention, a plurality of raw materials of powder form are uniformly mixed to obtain a raw material mixture; the mixture is reacted at a high temperature in a plasma apparatus; the reaction product is further reacted in a furnace to obtain a high temperature superconducting material; the material is kneaded with a solvent and a dispersant to obtain a slip. This slip is casted into a desired mold or coated on a substrate, followed by sintering, whereby a high temperature superconducting material can be produced. In this process, since the raw materials of ultrafine powder form are used, their reactivity is very high and moreover their reaction is uniform. Thus, there can be produced a high temperature superconducting material of excellent superconducting properties in critical magnetic field and critical current density.

In the present specification, ultrafine powder refer to those having an average particle diameter of 0.1 $\mu$m or less.

The present invention is specifically explained below by way of the following Examples.

Example 1

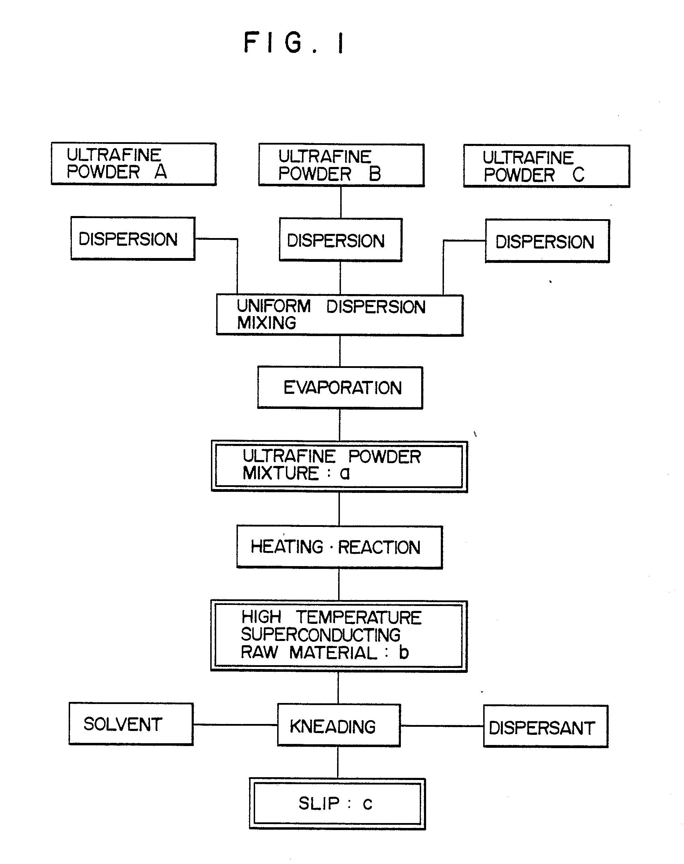

Fig. 1 is a flow chart explaining an example of a process for producing a high temperature superconducting material according to the present invention. In the process of Fig. 1, there are weighed, as three raw materials of ultrafine powder form giving a stoichiometric composition, 11.3 g of $Y_2O_3$ (raw material A), 39.5 g of $BaCO_3$ (raw material B) and 23.9 g of CuO (raw material C). All of these raw materials are ultrafine powders having particle diameters of 1,000 Å or less. Each raw material is placed in a different container and mixed with acetone (a volatile organic solvent) in the container. Since ultrafine powders are active and their particles cause agglomeration, each of the resulting mixtures is subjected to ultrasonic vibration to thoroughly disperse the particles of each of ultrafine powder. Then, the resulting three dispersions are mixed and the mixture is subjected again to ultrasonic vibration for uniform dispersion. Thereafter, the organic solvent is removed by evaporation. The ultrafine powder mixture obtained is designated as an ultrafine powder mixture "a".

In the above, acetone as a volatile organic solvent can be replaced by other organic solvent (e.g. ethyl alcohol) which does not react with the ultrafine powders. When the oxides as raw materials react with the organic solvent used, carbonates can be used in place of the oxides.

The ultrafine powder mixture "a" comprising the components A, B and C is placed in a furnace and reacted at 950°C in an oxygen atmosphere. Then, the reaction product is cooled from 950°C to 200°C in 4 hours to obtain a high temperature superconducting raw material ($YBa_2Cu_3O_{7-\delta}$) "b" having a perovskite type structure.

Since the ultrafine powder mixture "a" is a mixture of raw materials of ultrafine powders, the mixture "a" has high reactivity, makes uniform reaction, and accordingly can produce a compound of the above composition at a low reaction temperature.

When the raw material A or B is a carbonate, the carbonate is first decomposed into an oxide and $CO_2$ or CO and then this oxide and other oxides are reacted to produce a superconducting compound having a perovskite type crystal structure.

The high temperature superconducting raw material "b" obtained above is mixed with a solvent and a dispersant, and they are thoroughly kneaded to obtain a slip "c".

Example 2

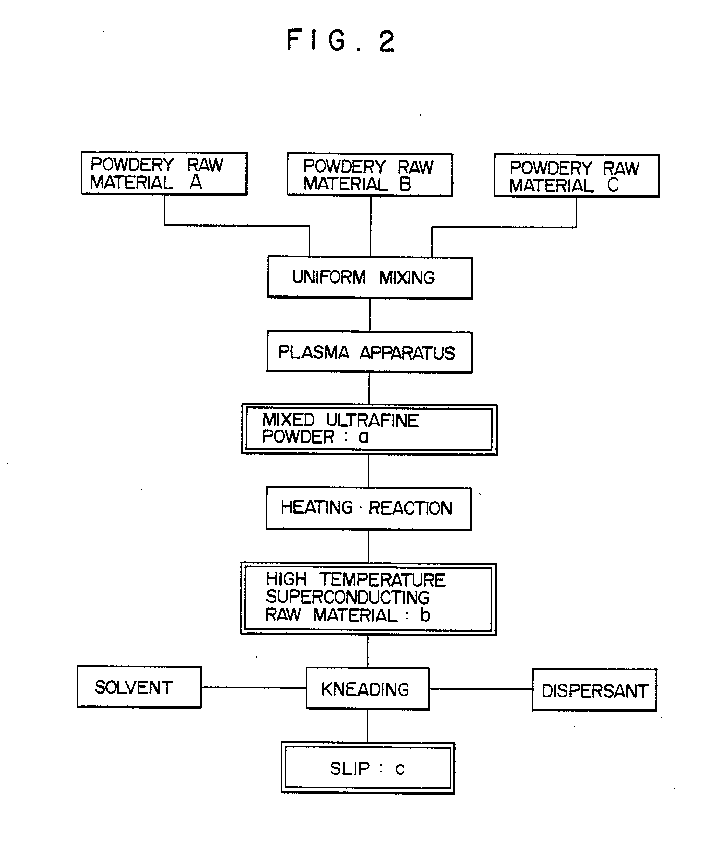

Fig. 2 is a flow chart explaining another example of a process for producing a high temperature superconducting material according to the present invention. In the process of Fig. 2, there are weighted, as three powdery raw materials giving stoichiometric composition $DyBa_2Cu_3O_{7-\delta}$, 18.7 g of $Dy_2O_3$ (raw material A), 30.7 g of BaO (raw material B) and 23.9 g of CuO (raw material C). The powdery materials A, B and C are placed in a ball mill and mixed uniformly in 24 hours to obtain a raw material mixture. This raw material mixture is fed into a high frequency plasma apparatus having a frequency of 13.56 MHz by a gas flow and reacted at a high temperature supplied by the high frequency plasma to obtain an ultrafine powder mixture "a". Almost all the particles of this mixture have particle diameters of 1,000 Å or less when the mixture is observed by an electron microscope, and accordingly the mixture is an ultrafine powder. Then, the ultrafine powder mixture "a" is placed in a furnace and reacted at 950°C in an oxygen atmosphere and the reaction product is cooled in the same manner as in Example 1 to obtain a high temperature superconducting material ($DyBa_2Cu_3O_{7-\delta}$) "b" having a perovskite type structure.

Since the ultrafine powder mixture "a" is a mixture of raw materials of ultrafine powder form, the mixture "a" has high reactivity, makes uniform reaction, and accordingly can produce a compound of the above composition at a low reaction temperature. The atmosphere used in the reaction of the ultrafine powder mixture "a" is preferably air, a mixed atmosphere of oxygen and argon or nitrogen, or oxygen.

When the raw material A or B is a carbonate, the carbonate is first decomposed into an oxide and $CO_2$ or CO and then this oxide and other oxides are reacted to produce a superconducting compound having a perovskite type crystal structure.

The high temperature superconducting raw material b obtained above is mixed with a solvent and a dispersant, and they are thoroughly kneaded to obtain a slip "c".

Example 3

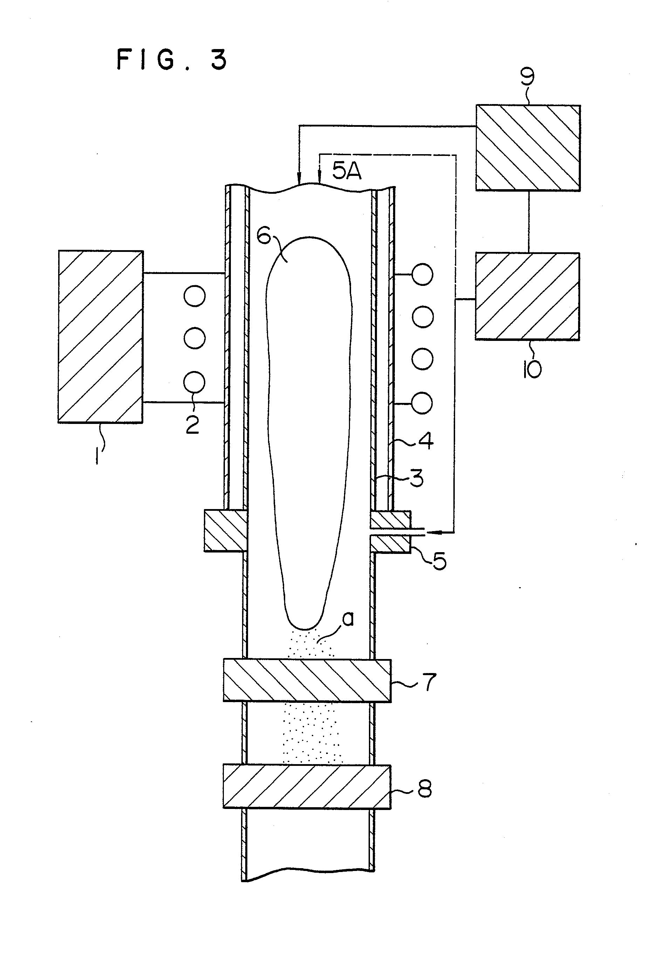

Fig. 3 is a view showing the constitution of the high frequency plasma apparatus used in Example 2 for reacting the raw material mixture to obtain an ultrafine powder mixture "a". By referring to Fig. 3, a step for production of an ultrafine powder mixture by high frequency plasma is explained. In Fig. 3, 1 is a high frequency powder source, and 2 is an induction coil. Application of a high frequency to this induction coil generates a plasma 6 inside an inner tube 3. To prevent the temperature increase of the inner tube 3 brought about by the plasma, cooling water (not shown) is flown between the inner tube 3 and an outer tube 4. 5 is works for feeding a powder mixture; 7 is a cooling section; 8 is a section for collecting an ultrafine powder mixture "a" obtained. A uniform raw material mixture is fed to the tail portion of the plasma 6 through the works 5 by the flow of part of the gas supplied from a gas-feeding device 9. The raw material mixture is reacted by the high temperature of the plasma 6, whereby an ultrafine powder mixture "a" is produced. The mixture "a" is cooled at the cooling section 7 and collected at the collection section 8.

The works 5 may alternatively be provided at a position 5A. In this case, the plasma 6 becomes slightly unstable; however, a similar effect can be obtained by appropriately controlling the type and amount of the gas to be fed into the plasma apparatus.

This Example is a case of reacting a raw material mixture by means of a high frequency plasma. However, other plasma, a laser beam, an electron beam, etc. can be alternatively used to obtain the same effect, as long as they can provide an energy sufficient for the high temperature reaction of the raw material mixture.

Example 4

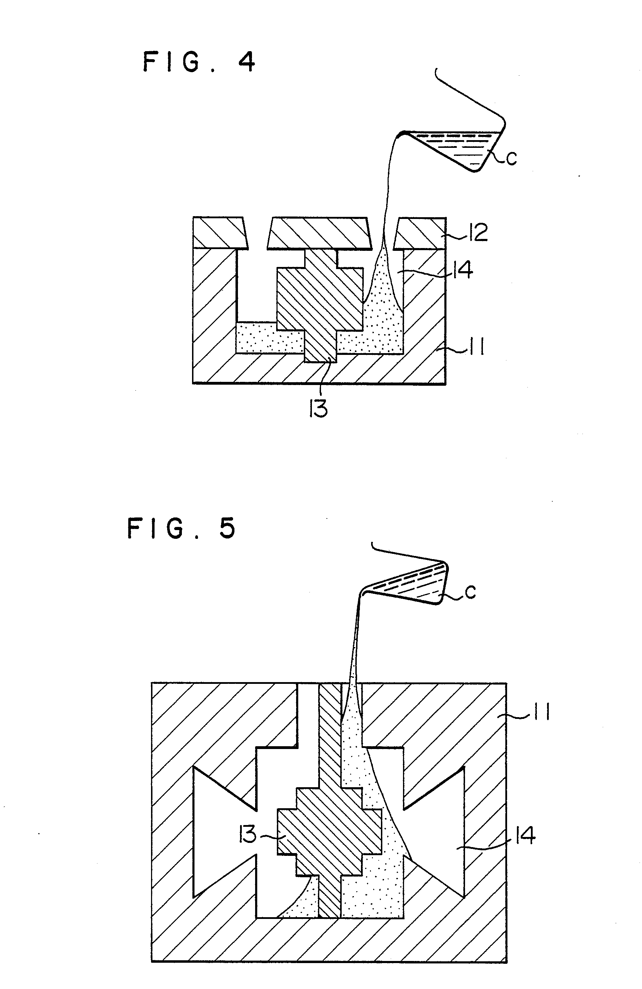

As shown in Fig. 4, around the center of a drag 11 made of gypsum used in ceramic production is set a core 13 prepared by uniformly mixing 92 parts by weight ("parts by weight" is hereinafter referred to as "parts") of alumina (250-325 meshes), 8 parts of $K_2CO_3$ and 6.5 parts of water, subjecting the resulting mixture to molding, drying the molding at 200°C for 1 hour and then cooling it to room temperature. There is further set a cope 12 made of gypsum used in ceramic production, whereby a mold is completed.

Separately, each of the high temperature superconducting raw materials "b" obtained in Example 1 (Fig. 1) and Example 2 (Fig. 2) is mixed with water and a dispersant, and they are kneaded in a ball mill for 24 hours to obtain a uniform slip "c".

This slip "c" is casted into a cavity 14 in the above mold. The slip begins to solidify owing to the absorption of the water present in the slip by the master mold and core. At this time, the core loses its strength because of the dissolution of the binder ($K_2CO_3$) in the water absorbed. The solidified slip (green body) causes slight shrinkage owing to dehydration but has no cracks because the core 13 loses the strength significantly.

Further, loss of the strength of the core 13 make the removal of the core 13 very easy.

The thus obtained green body is dried at a low temperature (70°C), heated at 900°C for 10 hours in an oxygen-containing atmosphere, and then cooled to 200°C in 4 hours to obtain a shaped article having superconducting properties.

Example 5

A mold material is prepared by uniformly mixing 100 parts of $Al_2O_3$ (250-325 meshes) and 20 parts of an aqueous solution containing 5% of a polyvinyl alcohol.

Using Wooden patterns and the above mold material, a core 13 and a two-portion master mold 11 are made, and they are combined to prepare a mold, as shown in Fig. 5.

Incidentally, the core 13 and the master mold 11 had been sufficiently dried at 100°C and solidified before use.

Separately, each of the high temperature superconducting raw materials "b" obtained in Example 1 (Fig. 1) and Example 2 (Fig. 2) is mixed with a required amount of a solvent (water) and a dispersant, and they are kneaded in a ball mill for 20 hours to obtain a uniform slip "c".

This slip "c" is casted into a cavity 14 in the above mold and allowed to stand for 1 hour to solidify the slip.

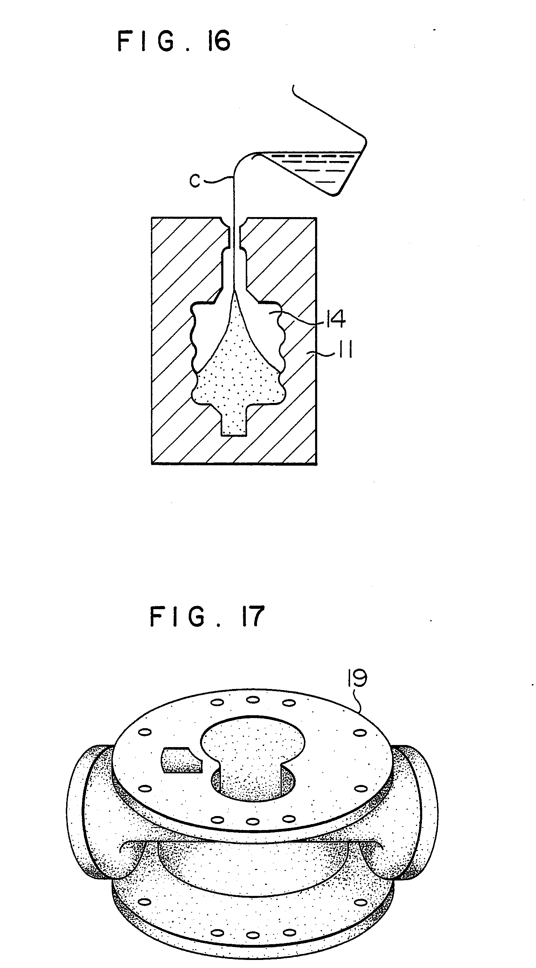

The core 13 and the master mold 11 significantly reduce their strengths owing to the absorption of the water present in the slip and accordingly can be easily disintegrated and removed, whereby a green body 16 as shown in Fig. 16 can be obtained. The green body has no cracks because the core used in this Example shows no resistance to the contraction of the slip.

Example 6

A mold slurry 20 is prepared by uniformly mixing 100 parts of calcined gypsum, 8 parts of a cellulose powder (under 300 meshes) and 75 parts of water.

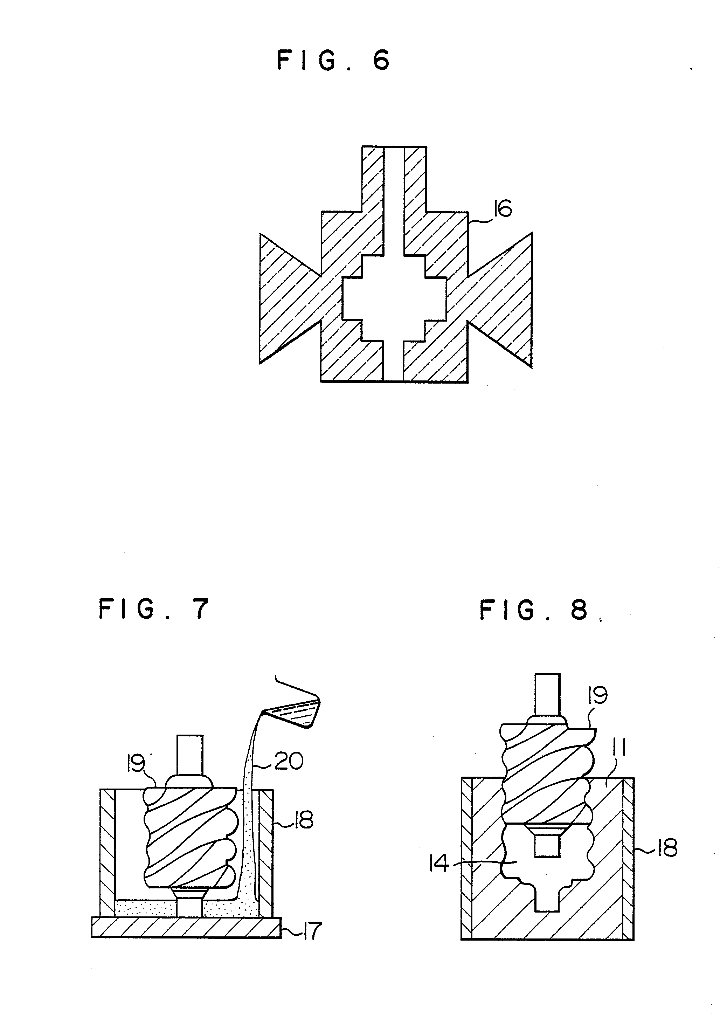

As shown in Fig. 7, a molding flask 18 is placed on a molding board 17, and a rotor pattern 19 is set around the center of the molding flask. Then, the above mold slurry 20 is poured into the remaining space in the molding flask.

As shown in Fig. 8, the pattern 19 is removed by pulling after the solidification of the mold slurry, whereby a drag is obtained. This drag is combined with a cope separately prepared in the same manner as above, to complete a rotor mold and thereby to form a mold cavity 14.

Each of the high temperature superconducting raw materials "b" obtained in Example 1 (Fig. 1) and Example 2 (Fig. 2) is mixed with a required amount of a solvent (water) and a dispersant, and they are kneaded in a ball mill for 24 hours to obtain a uniform slip "c".

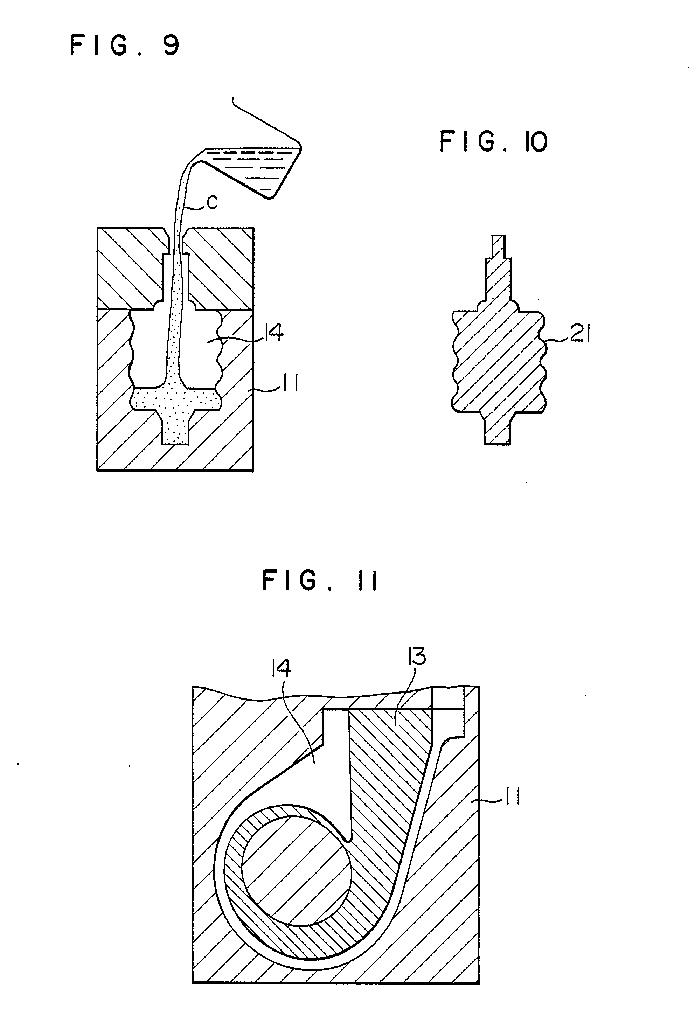

As shown in Fig. 9, this slip is casted into the cavity 14 in the above mold and allowed to stand to solidify, whereby a green body is obtained in the mold.

The mold containing the green body is slowly heated in an electric furnace of 70°C to dry the mold and the green body.

After the evaporation of the free water present in the mold and the green body, they are placed in a heating furnace and slowly heated from room temperature to 400°C and kept at 400°C for 2 hours to burn the cellulose in the mold and thereby to significantly reduce the mold's strength to 1 kg/cm$^2$ or less (bending strength).

The mold and the green body are taken out of the furnace and allowed to cool. The mold is separated from the green body.

The mold can be easily separated because it significantly reduced the strength as a result of heating, whereby a good green body 21 as shown in Fig. 10 can be obtained.

This green body 21 is heated at 900°C for 10 hours in an oxygen-containing atmosphere and then cooled to 200°C in 4 hours to obtain a rotor 21 having high temperature superconducting properties.

Example 7

A mold material is prepared by uniformly mixing 100 parts of calcined gypsum, 8 parts of a cellulose powder (under 300 meshes) and 75 parts of water.

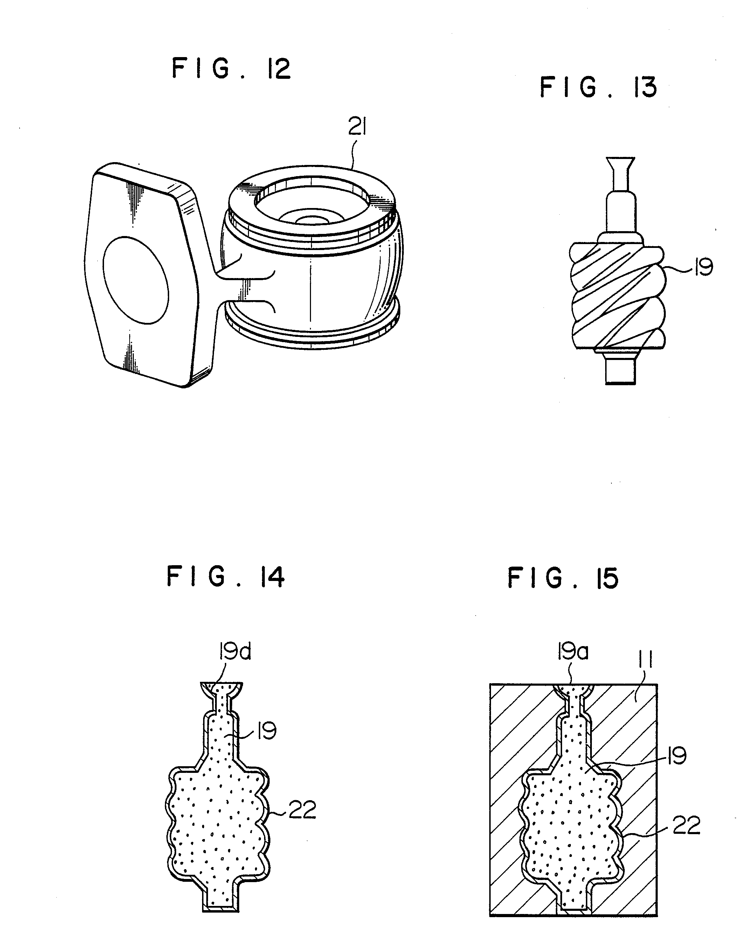

Using this mold material, a core 13 and a master mold 11 are produced, and they are combined into a mold for turbocharger casing as shown in Fig. 11.

The mold is heated from room temperature to 400°C in 3 hours in a furnace, kept at 400°C for 1 hour and then allowed to cool in the furnace. As a result of this heat treatment, the cellulose burns; gypsum reduces its strength; and the mold reduces its strength to about 0.5 kg/cm$^2$

(compression strength).

Each of the high temperature superconducting raw materials "b" obtained in Example 1 (Fig. 1) and Example 2 (Fig. 2) is mixed with a required amount of a solvent (water) and a dispersant, and they are kneaded for 24 hours in a ball mill to obtain a uniform slip (c).

This slip is casted into a cavity 14 in the above mold and allowed to stand to solidify and thereby to obtain a green body 21.

Then, the green body 21 is separated from the mold, as shown in Fig. 12.

The core 13, although having a gyrate form, can be easily removed because its strength is reduced. The green body 21 has no cracks and is of good quality.

The thus obtained green body is sintered to obtain a good sintered product 4 of superconducting turbocharger casing.

Example 8

On a pattern 19 of Fig. 13 for male rotor of screw compressor, made of a foamed polystyrol (foaming magnification: 50 times) is formed a silicone rubber film 22 of 20 μm in thickness, as shown in Fig. 14. The film 22 is formed on the entire surface of the pattern 19 except the upper end 19a of the sprue.

As shown in Fig. 15, the pattern 19 with the film 22 is placed in a molding flask (not shown), and a mold slurry comprising 100 parts of gypsum, 8 parts of a cellulose powder (under 300 meshes) and 75 parts of water is casted into the remaining space in the flask. After the mold slurry solidified, acetone is poured into the pattern from the sprue. Starting from the upper portion, the pattern dissolved in acetone rapidly, and the dissolution residue adheres to the inner surface of the silicone rubber film.

The silicone rubber film 22 containing the dissolution residue and a slight amount of the acetone solution can be easily removed by pulling up the upper end of the film with a pincette, whereby a mold 11 having a desired cavity 14 as shown in Fig. 16 can be obtained.

This process allows easy production of a mold of complex form in one piece.

The mold 11 is heated at 400°C for 3 hours to significantly reduce its strength.

Each of the high temperature superconducting raw materials "b" obtained in Example 1 (Fig. 1) and Example 2 (Fig. 2) is kneaded with a required amount of water and a dispersant in a ball mill for 24 hours to obtain a slip "c". This slip is casted into the cavity 14 of the mold 11.

After solidifying the slip "c", the mold is removed to obtain a good green body.

The green body is heated at 900°C for 10 hours in an oxygen-containing atmosphere and then cooled to 200°C in 4 hours, whereby a superconducting rotor can be obtained.

Example 9

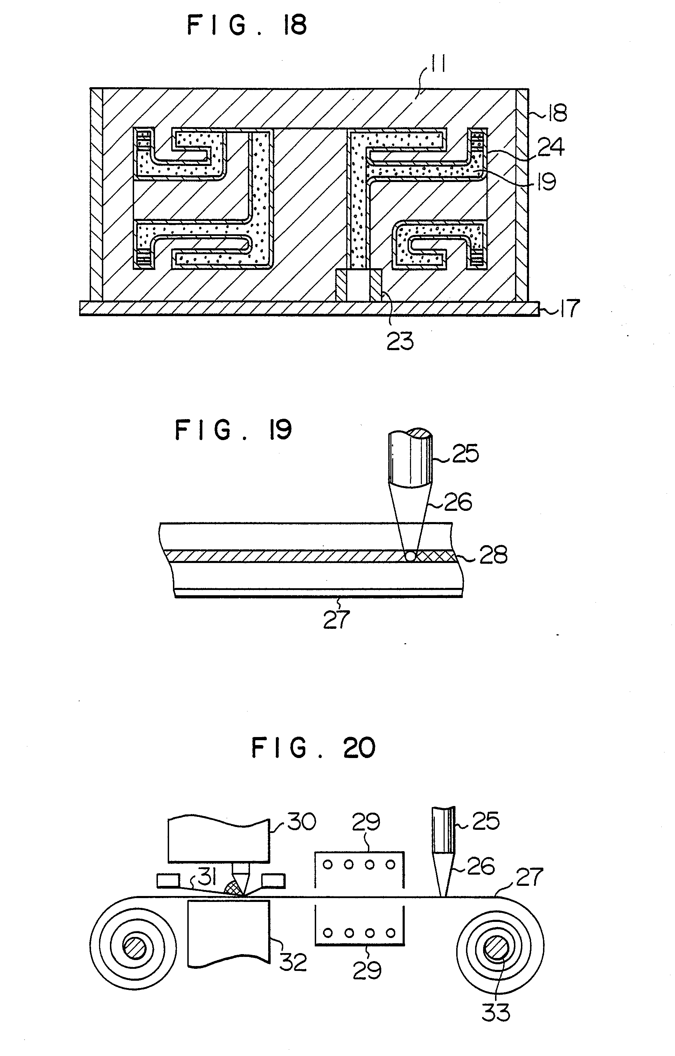

As shown in Fig. 17 and Fig. 18, a 15% aqueous polyvinyl alcohol solution is coated on the entire surface (except the upper end of the sprue) of a pattern 19 for screw compressor casing, made of a foamed polystyrol (foaming magnification: 50 times), to form a film 24 to 20 μm in thickness on the pattern 19.

The pattern 19 with the film 24 is set in a molding flask 18. A mold slurry consisting of 100 parts of calcined gypsum, 8 parts of cellulose and 75 parts of water is poured into the remaining space in the flask and solidified to prepare a mold 11.

Then, the mold 11 is turned upside and down, the molding board 17 is removed, and trichloroethane is poured from the ceramic sprue 23.

Trichloroethane does not penetrate into the mold owing to the presence of the polyvinyl alcohol film 24 and effectively dissolved only the pattern. After a uniform solution is obtained, the solution is discharged out of the mold. By repeating the same procedure, there is obtained a state where no pattern remained in the resulting cavity and only the polyvinyl alcohol film 24 remained.

Then, the mold is heated at 400°C for 3 hours to burn out the polyvinyl alcohol film and the cellulose in the mold. As a result, the mold significantly reduces its original strength to 0.5-1 kg/cm² (bending strength).

Each of the high temperature superconducting new materials "b" obtained in Example 1 (Fig. 1) and Example 2 (Fig. 2) is kneaded with a required amount of water and a dispersant for 24 hours in a ball mill to obtain a slip "c". This slip is casted into the cavity in the above mold and allowed to stand for solidification to obtain a green body.

The green body can be easily separated from the mold because the mold has already reduced its strength significantly.

When the above casing is produced according to an ordinary process using a number of gypsum molds in combination, 20-30 molds are required, causing various problems in practical production, such as inaccurate dimension, flash formation, crack formation in green body and inconvenience of using many process steps.

In the process of this Example, however, a good molding can be obtained without any special skill and inexpensively, using a one-piece mold.

The thus obtained casing is heated at 900°C in an oxygen-containing atmosphere and then cooled to 200°C in 4 hours, whereby a superconducting casing could be obtained.

Example 10

In Fig. 19 and Fig. 20, there is explained an example of (a) coating on a metal tape a paste (slip "c") obtained by dispersing each of the high temperature superconducting raw materials "b" of Example 1 (Fig. 1) and Example 2 (Fig. 2) in an organic solvent and then (b) sintering the paste by laser beam irradiation.

In an organic solvent was dispersed a high temperature superconducting raw material "b" of ultrafine powder form having high absorptivity and good sinterability and easy to sinter, to obtain a slip "c" (paste). In the drawings, 25 is a laser oscillator; 26 is a laser beam; 27 is a metal tape; 28 is a film formed by casting a slip "c" (paste) which is a dispersion of a high temperature superconducting raw material "b" in an organic solvent; 29 is a heating furnace; 30 is a printing apparatus; 31 is a printing mask; 32 is a printing stand; 33 is a winder.

The slip "c" (paste) is coated on a metal tape, dried in a heating furnace 29 and sintered with a laser beam 26. This process is conducted using an apparatus as shown in Fig. 20, whereby a high temperature superconducting material can be produced continuously.

On the metal tape which is to be moved by a winder 33 is printed the above prepared slip "c" (paste) by a thick film-printing apparatus 20. The printed paste is dried by a heating furnace 29 provided above and below the tape. Then, a laser beam is applied to the paste at the outlet of the heating furnace to calcinate the paste. Then, the tape is rolled round the winder, whereby a high temperature superconducting tape can be produced continuously.

## Claims

1. A process for producing a high temperature super conducting material, which comprises:

a first step of uniformly dispersing and mixing a plurality of raw materials of ultrafine powder form in a predetermined stoichiometric composition to obtain an ultrafine powder mixture,

a second step of reacting the ultrafine powder mixture in a furnace to obtain a high temperature superconducting raw material, and

a third step of uniformly dispersing the high temperature superconducting raw material in a solvent to obtain a slip.

2. A process according to Claim 1, wherein the plurality of raw materials of ultrafine powder form are seperetely dispersed in advance and the resulting dispersions are mixed to obtain an ultrafine powder mixture.

3. A process according to Claim 1, wherein the raw materials of ultrafine powder form each have particle diameters of 1,000 Å or less.

4. A process according to Claim 1, wherein the raw materials of ultrafine powder form used in the first step comprises three components, the first component being copper oxide (CuO) and the second and third components being two elements selected from oxides of Sr, Ba, Y and rare earth elements.

5. A process according to Claim 1, wherein the first step is conducted by immersing a plurality of raw materials of ultrafine powder form in a volatile organic solvent, subjecting the resulting mixture to ultrasonic vibration and then evaporating the solvent from the mixture.

6. A process according to Claim 1, wherein the second step is conducted at a high temperature of 600 to 1,050°C at highest.

7. A process according to Claim 1, which comprises further steps of (a) pouring the slip into a cavity contained in a mold, at least one portion of the mold being made of potassium carbonate and water, to allow the master mold and core of the mold to absorb the water present in the slip and thereby to reduce the strength of the core and obtain a solidified slip and then (b) sintering the solidified slip in a furnace.

8. A process according to Claim 1, which comprises further steps of (a) pouring the slip into a cavity contained in a mold, at least one portion of the mold being made of alumina, a polyvinyl alcohol and water, to allow the mold to absorb the water present in the slip and thereby to reduce the strength of the mold and obtain a solidified slip and then (b) calcinating the solidified slip in a furnace.

9. A process according to Claim 1, which comprises further steps of (a) pouring the slip into a cavity contained in a mold, at least one portion of the mold being made of calcined gypsum, a cellulose powder and water, to solidify the slip, (b) heating the mold containing the solidified slip in a furnace to reduce the strength of the mold and isolate the solidified slip and then (c) sintering the solidified slip in a furnace.

10. A process according to Claim 1, which comprises further steps of (a) pouring the slip into a cavity in a mold, at least one portion of the mold being made of gypsum, a cellulose powder and water and the mold and cavity being formed by placing a polystyrol pattern having a silicone rubber film thereon in a molding flask, pouring a slurry into the flask and solidifying the slurry, dissolving the pattern with an organic solvent to chemically remove the pattern and then physically removing the silicone rubber film, (b) solidifying the slip in the mold, (c) heating the mold containing the solidified slip in a furnace to reduce the strength of the mold and isolate the solidified slip and then (d) sintering the solidified slip.

11. A process according to Claim 1, which comprises further steps of (a) coating the slip on a substrate on a metal tape and (b) irradiating the coated surface with a laser beam.

12. A process for producing a high temperature superconducting material, which comprises:

a first step of uniformly mixing a plurality of raw materials of powder form in a predetermined stoichiometric composition to obtain a raw material mixture,

a second step of reacting the raw material mixture in a plasma apparatus at a high temperature to obtain an ultrafine powder mixture,

a third step of reacting the ultrafine powder mixture in a furnace to obtain a high temperature superconducting raw material having superconducting properties, and

a fourth step of uniformly dispersing the high temperature superconducting raw material in a solvent to obtain a slip.

13. A process according to Claim 12, wherein the superconducting raw materials of the first step comprises three components, the first being a copper oxide (CuO) and the second and third components being two elements selected from oxides of Sr, Ba, Y and rare earth elements.

14. A process according to Claim 12, wherein as a part of the second and third components of the superconducting raw material, there is used carbonates.

15. A process according to Claim 12, wherein the plasma apparatus of the second step is a high frequency plasma apparatus.

16. A process according to Claim 12, wherein the ultrafine powder mixture obtained in the second step has particle diameters of 1,000 Å or less.

17. A process according to Claim 12, wherein the ultrafine powder mixture obtained in the second step is reacted in a furnace at a temperature of 600 to 1,050°C at highest.

18. A process according to Claim 12, which comprises further steps of (a) pouring the slip into a cavity contained in a mold, at least one portion of the mold being made of potassium carbonate and water, to allow the master mold and core of the mold to absorb the water present in the slip and thereby to reduce the strength of the core and obtain a solidified slip and then (b) sintering the solidified slip in a furnace.

19. A process according to Claim 12, which comprises further steps of (a) pouring the slip into a cavity contained in a mold, at least one portion of the mold being made of alumina, a polyvinyl alcohol and water, to allow the mold to absorb the water present in the slip and thereby to reduce the strength of the mold and obtain a solidified slip and then (b) sintering the solidified slip in a furnace.

20. A process according to Claim 12, which comprises further steps of (a) pouring the slip into a cavity contained in a mold, at least one portion of the mold being made of calcined gypsum, a cellulose powder and water, to solidify the slip, (b) heating the mold containing the solidified slip in a furnace to reduce the strength of the mold and isolate the solidified slip and then (c) sintering the solidified slip in a furnace.

21. A process according to Claim 12, which comprises further steps of (a) pouring the slip into a cavity in a mold, at least one portion of the mold being made of gypsum, a cellulose powder and water and the mold and cavity being formed by placing a polystyrol pattern having a silicone rubber film thereon in a molding flask, pouring a slurry into the flask and solidifying the slurry, dissolving the pattern with an organic solvent to chemically remove the pattern and then physically removing the silicone rubber film, (b) solidifying the slip in the mold, (c) heating the mold containing the solidified slip in a furnace to reduce the strength of the mold and isolate the solidified slip and then (d) sintering the solidified slip.

22. A process according to Claim 12, which comprises further steps of (a) coating the slip on a substrate on a metal tape and (b) irradiating the coated surface with a laser beam.

# F I G . 1

```
┌─────────────┐      ┌─────────────┐      ┌─────────────┐
│ ULTRAFINE   │      │ ULTRAFINE   │      │ ULTRAFINE   │
│ POWDER  A   │      │ POWDER  B   │      │ POWDER  C   │
└─────────────┘      └─────────────┘      └─────────────┘

┌─────────────┐      ┌─────────────┐      ┌─────────────┐
│ DISPERSION  │      │ DISPERSION  │      │ DISPERSION  │
└─────────────┘      └─────────────┘      └─────────────┘

              ┌───────────────────────┐
              │ UNIFORM  DISPERSION    │
              │ MIXING                 │
              └───────────────────────┘

              ┌───────────────────────┐
              │ EVAPORATION           │
              └───────────────────────┘

              ┌───────────────────────┐
              │ ULTRAFINE  POWDER     │
              │ MIXTURE : a           │
              └───────────────────────┘

              ┌───────────────────────┐
              │ HEATING · REACTION    │
              └───────────────────────┘

              ┌───────────────────────┐
              │ HIGH  TEMPERATURE     │
              │ SUPERCONDUCTING       │
              │ RAW  MATERIAL : b     │
              └───────────────────────┘

┌──────────┐    ┌───────────┐    ┌──────────────┐
│ SOLVENT  │────│ KNEADING  │────│ DISPERSANT   │
└──────────┘    └───────────┘    └──────────────┘

              ┌───────────────────────┐
              │ SLIP : c              │
              └───────────────────────┘
```

# F I G . 2

```
┌─────────────────┐   ┌─────────────────┐   ┌─────────────────┐
│ POWDERY  RAW    │   │ POWDERY  RAW    │   │ POWDERY  RAW    │
│ MATERIAL  A     │   │ MATERIAL  B     │   │ MATERIAL  C     │
└─────────────────┘   └─────────────────┘   └─────────────────┘

              ┌─────────────────────────┐
              │   UNIFORM  MIXING       │
              └─────────────────────────┘

              ┌─────────────────────────┐
              │   PLASMA  APPARATUS     │
              └─────────────────────────┘

              ┌─────────────────────────┐
              │  MIXED  ULTRAFINE       │
              │  POWDER : a             │
              └─────────────────────────┘

              ┌─────────────────────────┐
              │  HEATING · REACTION     │
              └─────────────────────────┘

              ┌─────────────────────────┐
              │  HIGH  TEMPERATURE      │
              │  SUPERCONDUCTING        │
              │  RAW  MATERIAL : b      │
              └─────────────────────────┘

┌──────────┐   ┌─────────────┐   ┌──────────────┐
│ SOLVENT  │───│  KNEADING   │───│ DISPERSANT   │
└──────────┘   └─────────────┘   └──────────────┘

              ┌─────────────────────────┐
              │     SLIP : c            │
              └─────────────────────────┘
```

# FIG. 3

FIG. 4

FIG. 5

# FIG. 6

# FIG. 7

# FIG. 8

## FIG. 9

## FIG. 10

## FIG. 11

F I G . 12

F I G . 13

21

19

F I G . 14

F I G . 15

19d

19a

11

19

19

22

22

# FIG. 16

C

14

11

# FIG. 17

19

FIG. 18

FIG. 19

FIG. 20